# DEMANDE DE BREVET EUROPEEN

(11) **EP 4 002 486 A1**
(43) Date de publication de la demande: **25.05.2022**
(21) Numéro de dépôt: 21208507.0
(22) Date de dépôt: 16.11.2021
(51) Int. Cl.: H01L 29/786, H01L 29/66

(54) **PROCÉDÉ DE FABRICATION D'UNE ZONE DOPÉE D'UN DISPOSITIF MICROÉLECTRONIQUE**

(30) Priorité: 18.11.2020 FR 2011822
(71) Demandeur: Commissariat à l'Energie Atomique et aux Energies Alternatives, 75015 Paris (FR)
(72) Inventeur: REBOH, Shay, 38054 GRENOBLE Cedex 09 (FR)
(74) Mandataire: Hautier, Nicolas

(57) **Abrégé**

L'invention concerne un procédé de formation d'une zone dopée (13) d'un transistor (1), comprenant les étapes suivantes :
- Fournir un empilement comprenant au moins une couche active (12) en un matériau semi-conducteur, et un motif de grille (10) de transistor présentant au moins un flanc latéral (100),
- Modifier une portion de la couche active (12) de sorte à former une portion modifiée (12m) en un matériau semi-conducteur modifié, ladite portion modifiée (12m) s'étendant jusqu'à l'aplomb de l'au moins un flanc latéral (100) du motif de grille (10), en bordure d'une portion non modifiée (12e, 15) surmontée par le motif de grille (10),
- Former un espaceur (11) sur ledit flanc latéral (100),
- Retirer la portion modifiée (12m) par gravure sélective du matériau semi-conducteur modifié vis-à-vis du matériau semi-conducteur de la portion non modifiée (12e, 15), de sorte à exposer un bord (150) de ladite portion non modifiée (12e, 15),
- Former la zone dopée (13) par épitaxie à partir dudit bord (150) exposé.

## Description

### DOMAINE TECHNIQUE

La présente invention concerne le domaine de la microélectronique. Elle trouve pour application particulièrement avantageuse la réalisation de sources et drains dans des transistors requérant de faibles budgets thermiques, notamment dans le domaine de l'intégration 3D monolithique.

### ETAT DE LA TECHNIQUE

Historiquement, les développements de l'industrie des semi-conducteurs visent à suivre, à travers une feuille de route commune, la loi de Moore, qui prévoit le doublement de la densité des puces électroniques tous les dix-huit mois environ. Les nœuds technologiques jalonnant cette feuille de route sont généralement définis par la finesse de gravure des transistors des circuits intégrés.

Pour les nœuds technologiques dont la finesse de gravure est inférieure à 10 nm, les développements requis sont extrêmement complexes et coûteux. Une solution alternative aux nœuds technologiques les plus avancés, relâchant une partie des contraintes liées à la finesse de gravure, consiste à intégrer les transistors selon une architecture tridimensionnelle (3D). Ce concept d'intégration 3D est une solution prometteuse pour améliorer globalement les critères relatifs de puissance/performance/encombrement/coût des circuits intégrés, selon une démarche dite « More than Moore » (ou « au-delà de la loi de Moore », en français) tout en permettant une co-intégration de différents dispositifs sur différents niveaux.

Parmi les procédés d'intégration 3D à très grande échelle (ou 3D VLSI pour *Very Large Scale Integration* en anglais), le procédé d'intégration CoolCube^{™} propose de former des transistors les uns sur les autres de manière séquentielle. Une problématique de ce procédé concerne la gestion du budget thermique lors de la formation des couches supérieures de transistors. Afin de préserver les caractéristiques électriques optimales des transistors des couches inférieures de l'empilement, il faut limiter au maximum l'élévation de température lors des différentes étapes du procédé. En particulier, la formation de zones dopées de part et d'autre du canal du transistor, typiquement les zones de source et de drain du transistor, requiert classiquement une étape d'activation et/ou de diffusion des dopants, après implantation ionique d'espèces dopantes.

Une solution classique pour l'activation des dopants dans le cadre d'une technologie planaire consiste à effectuer un recuit thermique haute température, typiquement à une température T > 1000°C, après implantation des dopants.

Une solution existante pour l'activation des dopants dans le cadre d'une technologie d'intégration 3D consiste à amorphiser une partie de la couche semi-conductrice destinée à former les zones de source et de drain, avant ou pendant l'implantation des dopants. Après implantation des dopants, l'activation des dopants se fait lors de la recristallisation en phase solide de la couche semi-conductrice amorphe. Cette étape de recristallisation/activation peut se faire à plus basse température, typiquement à une température T < 600°C.

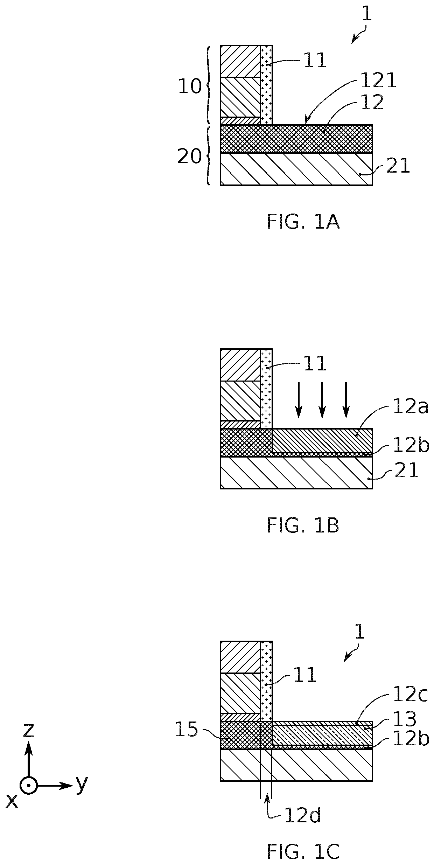

Les figures 1A-1C présentent les étapes d'un tel procédé de recristallisation appelé SPER (acronyme de « solid-phase epitaxial regrowth » selon la terminologie anglo-saxonne). La figure 1A illustre un dispositif 1 destiné à former un transistor et comprenant un motif de grille 10 flanqué d'un espaceur 11 sur un substrat 20 de type SOI (acronyme de « Silicon on Insulator » ou « silicium sur isolant » en français). L'espaceur 11 présente généralement des dimensions allant de 6nm à 40nm. La figure 1B illustre un bombardement d'ions en bordure de l'espaceur 11, adapté pour amorphiser partiellement la couche de silicium supérieure 12 (topSi) du substrat SOI, et pour implanter des dopants dans cette partie amorphe 12a. Une partie cristalline 12b de la couche topSi 12 est conservée à l'issue de ce bombardement, de façon à former un germe pour la future recristallisation. La figure 1C illustre la recristallisation partielle du topSi à partir de ce germe 12b. Lors de la recristallisation, les dopants sont incorporés et activés. Cette recristallisation permet *in fine* d'obtenir une zone dopée 13.

Un inconvénient de cette solution basée sur le procédé de recristallisation SPER est qu'il existe une zone non dopée 12d entre le canal 15 et la zone dopée 13, sous l'espaceur 11. Cette zone non dopée 12d présente une dimension selon l'axe y sensiblement identique à celle de l'espaceur 11. La présence de cette zone non dopée 12d a pour effet d'augmenter la résistance d'accès du transistor. Un autre inconvénient est la présence du germe 12b non dopé sous-jacent à la zone dopé 13. Cela augmente encore la résistance d'accès du transistor. En outre, pour de faibles épaisseurs de topSi, par exemple inférieures à 10 nm, un bon contrôle de la profondeur d'amorphisation devient essentiel. La mise en œuvre du procédé SPER est dès lors complexe. Par ailleurs, la recristallisation de la partie amorphe 12a du topSi n'est généralement pas complète. Une couche résiduelle superficielle 12c non cristallisée demeure, il est alors nécessaire de prévoir une gravure pour l'éliminer.

Les documents EP 2835832 A2 et US 2008/0242037 A1 présentent des solutions alternatives pour diminuer la résistance d'accès du transistor, qui ne sont néanmoins pas totalement compatibles avec les procédés d'intégration 3D.

Un objet de la présente invention est de pallier au moins en partie certains des inconvénients mentionnés ci-dessus.

En particulier, un objet de la présente invention est de proposer un procédé de formation d'une zone dopée améliorant la résistance d'accès d'un dispositif microélectronique.

Les autres objets, caractéristiques et avantages de la présente invention apparaîtront à l'examen de la description suivante et des dessins d'accompagnement. Il est entendu que d'autres avantages peuvent être incorporés.

### RESUME

Pour atteindre cet objectif, un premier aspect de l'invention concerne un procédé de formation d'au moins une zone dopée destinée à former l'un parmi une source ou un drain d'un transistor, comprenant les étapes suivantes :
- Fournir un empilement comprenant au moins une couche active en un matériau semi-conducteur s'étendant selon un plan basal, et un motif de grille de transistor surmontant la couche active et présentant au moins un flanc latéral s'étendant dans un plan sensiblement perpendiculaire à la couche active,
- Modifier une portion de la couche active selon toute l'épaisseur de la couche active de sorte à former une portion modifiée en un matériau semi-conducteur modifié, ladite portion modifiée s'étendant directement en bordure d'une portion non modifiée de la couche active à l'aplomb du motif de grille,
- Former un espaceur sur ledit flanc latéral,
- Retirer la portion modifiée par gravure sélective du matériau semi-conducteur modifié vis-à-vis du matériau semi-conducteur de la portion non modifiée, de sorte à exposer un bord de ladite portion non modifiée, ledit bord s'étendant sensiblement dans un prolongement du flanc latéral du motif de grille,
- Former par épitaxie à partir dudit bord exposé la zone dopée.

Ainsi la modification de la couche active est effectuée de sorte à former une portion modifiée s'étendant dans au moins une région de la couche active non surmontée par le motif de grille et s'étendant jusqu'à l'aplomb de l'au moins un flanc latéral du motif de grille. La région de la couche active qui est quant à elle surmontée par le motif de grille forme une portion non modifiée. Ainsi, l'interface entre la portion modifiée et la portion non modifiée est située au droit du flanc du motif de grille.

Avantageusement, la modification d'une portion de la couche active est effectuée avant la formation de l'espaceur. Dès lors, aucune portion de couche active n'est masquée par l'espaceur lors de cette modification. Cela permet de former une portion modifiée au plus près du motif de grille. Typiquement, pour une modification réalisée par implantation d'espèces dans la couche active selon une direction parallèle au flanc du motif de grille, l'interface entre la portion modifiée et la portion non modifiée à l'aplomb du motif de grille, s'étend sensiblement en prolongement du flanc, dans la couche active. Après retrait de la portion modifiée, cette interface forme le bord de la portion non modifiée. La formation de la zone dopée se fait à partir de ce bord. L'interface entre la portion non modifiée et la portion modifiée devient ainsi une jonction entre la portion non modifiée, typiquement le canal du transistor, et la zone dopée, typiquement la source ou le drain du transistor. Cette jonction est de préférence abrupte.

Un tel procédé supprime avantageusement la zone non dopée résiduelle qui se trouve à l'aplomb de l'espaceur, entre le canal et la zone dopée, lors de la mise en œuvre des procédés connus. La jonction ainsi obtenue permet de diminuer la résistance d'accès du transistor. Comme indiqué précédemment en référence à la figure 1B illustrant l'art antérieur, un bombardement effectué dans le cadre des solutions connues ne permet pas de faire disparaître la zone non dopée, même si ce bombardement était modifié de sorte à incliner la direction de bombardement.

La formation de la zone dopée par épitaxie latérale, c'est-à-dire à partir du bord de la portion non modifiée, permet en outre de s'affranchir de la nécessité de conserver un germe d'épitaxie sous la portion modifiée. Ainsi, la modification peut être effectuée sur toute l'épaisseur de la couche active, de sorte que la portion modifiée présente une épaisseur égale à celle de la couche active, et que, par suite, la zone dopée présente une épaisseur égale à celle de la couche active. Il n'est dès lors pas nécessaire de contrôler précisément une profondeur d'implantation, contrairement aux procédés connus. Cela permet de simplifier le procédé. Une zone dopée s'étendant selon toute la hauteur de la couche active permet en outre de diminuer la résistance d'accès du transistor.

Un tel procédé peut avantageusement être mis en œuvre à basse température, typiquement pour des températures T < 600°C. Ce procédé est ainsi compatible avec une technologie d'intégration 3D.

### BREVE DESCRIPTION DES FIGURES

Les buts, objets, ainsi que les caractéristiques et avantages de l'invention ressortiront mieux de la description détaillée d'un mode de réalisation de cette dernière qui est illustré par les dessins d'accompagnement suivants dans lesquels :
Les figures 1A à 1C illustrent en coupe des étapes de formation d'une zone dopée selon un procédé de l'art antérieur.
Les figures 2A à 2G illustrent en coupe des étapes de formation d'une zone dopée selon un mode de réalisation de la présente invention.
Les figures 3B à 3E illustrent en coupe des étapes de formation d'une zone dopée selon un autre mode de réalisation de la présente invention.
Les figures 4B à 4F illustrent en coupe des étapes de formation d'une zone dopée selon encore un autre mode de réalisation de la présente invention.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques En particulier, les dimensions relatives des différentes couches, portions et éléments du dispositif (par exemple espaceur, couche active, portions modifiées et non modifiées) ne sont pas représentatives de la réalité. Sur les dessins, un seul côté de la grille et un seul espaceur sont représentés. Il est entendu que le procédé s'applique de façon symétrique au deuxième côté de la grille et au deuxième espaceur. Ainsi, les figures peuvent être étendues par symétrie de part et d'autre de l'axe z.

### DESCRIPTION DÉTAILLÉE

Avant d'entamer une revue détaillée de modes de réalisation de l'invention, sont énoncées ci-après des caractéristiques optionnelles qui peuvent éventuellement être utilisées en association ou alternativement :
Selon un exemple, la modification de la portion de couche active formant la portion modifiée se fait selon toute l'épaisseur de la couche active.
Selon un exemple, la sélectivité de la gravure du matériau semi-conducteur modifié vis-à-vis du matériau semi-conducteur est supérieure ou égale à 10 :1, et de préférence supérieure ou égale à 20 :1.
Selon un exemple, la formation de l'espaceur comprend au moins un dépôt d'une couche diélectrique au moins sur le motif de grille suivi d'une gravure partielle de ladite couche diélectrique de sorte à retirer ladite couche diélectrique en dehors de l'au moins un flanc latéral, et le retrait de la portion modifiée est effectué par ladite gravure partielle.
Selon un exemple, le procédé comprend en outre, après modification de la portion de la couche active et avant formation de l'espaceur, une formation d'une couche de protection sur une face exposée de la portion modifiée, ladite couche de protection étant retirée après formation de l'espaceur et avant retrait de la portion modifiée.
Selon un exemple, la modification de la portion de la couche active est effectuée de sorte à ce que la portion modifiée soit amorphe, ladite portion non modifiée étant cristalline.
Selon un exemple, la modification de la portion de la couche active est effectuée de sorte à ce que le matériau semi-conducteur modifié présente une composition chimique différente du matériau semi-conducteur.
Selon un exemple, la modification de la portion de la couche active se fait par implantation d'espèces au sein de la couche active, par exemple à partir d'un plasma.
Selon un exemple, le matériau semiconducteur de la couche active est pris parmi le silicium et le silicium-germanium.
Selon un exemple, la zone dopée est à base de silicium ou de silicium-germanium.
Selon un exemple, l'épitaxie de la zone dopée est configurée pour que ladite zone dopée s'étende au-delà d'une face supérieure de la couche active selon une direction sensiblement perpendiculaire à ladite face supérieure de la couche active.
Selon un exemple, l'épitaxie de la zone dopée est une épitaxie latérale principalement dirigée selon une direction parallèle à la face de la couche active.
Selon un exemple, la gravure sélective est anisotrope et principalement dirigée selon une direction perpendiculaire à la face de la couche active.
Selon un exemple, l'épitaxie de la zone dopée est configurée de façon à former une cavité sous la zone dopée.

Il est précisé que dans le cadre de la présente invention, le terme « sur », « surmonte », « recouvre » ou « sous-jacent » ou leurs équivalents ne signifient pas forcément « au contact de ». Ainsi par exemple, le dépôt d'une première couche sur une deuxième couche, ne signifie pas obligatoirement que les deux couches sont directement au contact l'une de l'autre, mais cela signifie que la première couche recouvre au moins partiellement la deuxième couche en étant soit directement à son contact soit en étant séparée d'elle par au moins une autre couche ou au moins un autre élément.

Une couche peut par ailleurs être composée de plusieurs sous-couches d'un même matériau ou de matériaux différents.

On entend par un substrat, une couche, un dispositif, « à base » d'un matériau M, un substrat, une couche, un dispositif comprenant : uniquement ce matériau M ou ce matériau M et éventuellement d'autres matériaux, par exemple des éléments d'alliage, des impuretés ou des éléments dopants. Ainsi, un espaceur à base de nitrure de silicium SiN peut par exemple comprendre du nitrure de silicium non stœchiométrique (SiN), ou du nitrure de silicium stœchiométrique (Si3N4), ou encore un oxy-nitrure de silicium (SiON).

En général, mais non limitativement, un espaceur forme une bague autour de la grille, avec un contour fermé ; la description d'un espaceur s'entend de préférence de cet espaceur unique autour de la grille ; cependant, les dessins d'illustration en coupe, généralement selon un plan transverse à la direction longitudinale des grilles, montrent deux parties d'espaceur de part et d'autre des flancs de la grille. Par extension, ces deux parties d'espaceur sont souvent désignées « les espaceurs ». Cette dernière terminologie peut éventuellement être adoptée dans cette demande. Par ailleurs, l'invention s'étend aux modes de réalisation dans lesquels au moins deux espaceurs discontinus recouvrent un motif de grille.

La présente invention permet notamment la fabrication d'au moins un transistor ou d'une pluralité de transistors sur un substrat. Ce substrat peut être massif ou « bulk » selon la terminologie anglo-saxonne, ou encore de type semi-conducteur sur isolant, par exemple un substrat silicium sur isolant SOI (acronyme de l'anglais « silicon on insulator) ou un substrat germanium sur isolant GeOI (acronyme de l'anglais « germanium on insulator »).

L'invention peut également être mise en œuvre plus largement pour différents dispositifs ou composants micro-électroniques.

Par composant, dispositif ou élément de dispositif microélectronique, on entend tout type d'élément réalisé avec les moyens de la microélectronique. Ces dispositifs englobent notamment en plus des dispositifs à finalité purement électronique, des dispositifs micromécaniques ou électromécaniques (MEMS, NEMS...) ainsi que des dispositifs optiques ou optoélectroniques (MOEMS...).

Plusieurs modes de réalisation de l'invention mettant en œuvre des étapes successives du procédé de fabrication sont décrits ci-après. Sauf mention explicite, l'adjectif « successif » n'implique pas nécessairement, même si cela est généralement préféré, que les étapes se suivent immédiatement, des étapes intermédiaires pouvant les séparer. Par ailleurs, le terme « étape » s'entend de la réalisation d'une partie du procédé, et peut désigner un ensemble de sous-étapes.

Le mot « diélectrique » qualifie un matériau dont la conductivité électrique est suffisamment faible dans l'application donnée pour servir d'isolant. Dans la présente invention, un matériau diélectrique présente de préférence une constante diélectrique inférieure à 7. Les espaceurs sont typiquement formés en un matériau diélectrique.

Le matériau semi-conducteur modifié est réputé différent du matériau semi-conducteur.

Les termes « motif de grille », «empilement de grille », « grille » sont employés en synonymes.

On entend par « gravure sélective vis-à-vis de » ou « gravure présentant une sélectivité vis-à-vis de » une gravure configurée pour enlever un matériau A ou une couche A vis-à-vis d'un matériau B ou d'une couche B, et présentant une vitesse de gravure du matériau A supérieure à la vitesse de gravure du matériau B. La sélectivité est le rapport entre la vitesse de gravure du matériau A sur la vitesse de gravure du matériau B.

Dans la présente demande de brevet, on parlera préférentiellement d'épaisseur pour une couche, de hauteur pour un dispositif (transistor ou grille par exemple) et de profondeur pour une cavité ou une gravure. L'épaisseur est prise selon une direction normale au plan d'extension principal de la couche, la hauteur et la profondeur sont prises selon une direction normale au plan de base du substrat. Le plan d'extension principale de la couche, respectivement le plan de base du substrat est généralement parallèle à une face inférieure ou une face supérieure de cette couche, respectivement de ce substrat.

Dans la présente demande de brevet, un repère de préférence orthonormé formé par les axes x, y, z est représenté sur les dessins d'accompagnement. Le substrat, plus précisément sa face inférieure et/ou sa face supérieure, s'étendent dans le plan basal xy.

Dans la suite, la longueur est prise selon la direction portée par l'axe x et la largeur est prise selon la direction portée par l'axe y.

Un élément situé « à l'aplomb d'» ou « au droit d'» un autre élément signifie que ces deux éléments sont situés tous deux sur une même ligne perpendiculaire au plan basal, soit sur une même ligne orientée selon l'axe z sur les figures. Un élément situé « en prolongement » d'un autre élément signifie que ces deux éléments sont orientés tous deux selon une même direction ou un même plan, et de préférence en continuité l'un de l'autre.

On entend par « horizontale » une orientation parallèle à un plan xy. On entend par « verticale » une orientation parallèle à l'axe z.

Les termes « sensiblement », « environ », « de l'ordre de » signifient « à 10% près » ou, lorsqu'il s'agit d'une orientation angulaire, « à 10° près ». Ainsi, une direction sensiblement normale à un plan signifie une direction présentant un angle de 90±10° par rapport au plan.

L'invention va maintenant être décrite en détail au travers de quelques modes de réalisation non limitatifs.

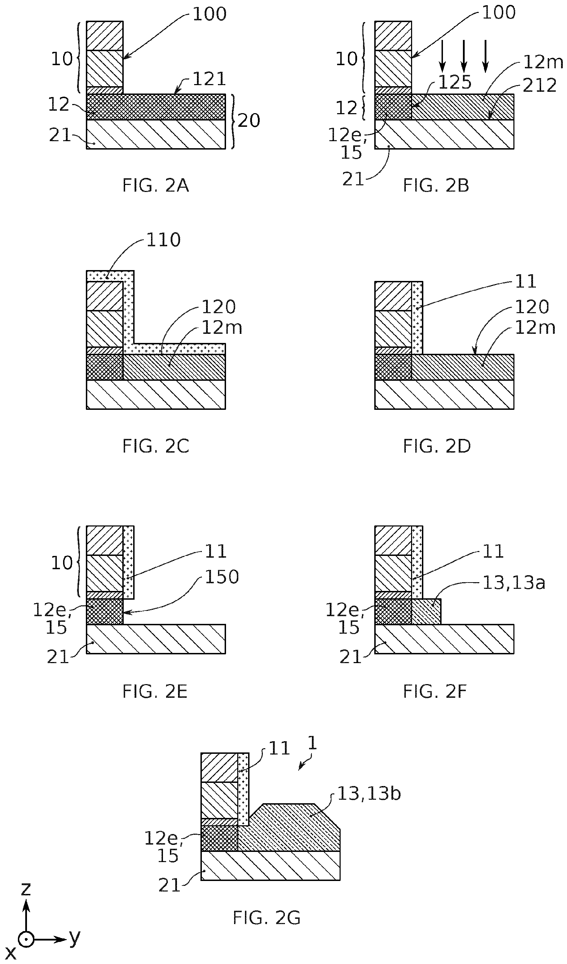

Un premier mode de réalisation du procédé est illustré aux figures 2A-2G.

Ce procédé est de préférence mis en œuvre sur une structure initiale comprenant un motif de grille 10 et un substrat 20, telle qu'illustrée à la figure 2A par exemple.

Le substrat 20 peut typiquement être un substrat de type semi-conducteur sur isolant, par exemple un substrat silicium sur isolant SOI (acronyme de l'anglais « silicon on insulator) ou un substrat germanium sur isolant GeOI (acronyme de l'anglais « germanium on insulator).

Un tel substrat 20 de type SOI comprend typiquement :
- un support en silicium massif présentant typiquement une épaisseur de plusieurs centaines de µm (non illustré) dénommé Si bulk (signifiant silicium massif),
- une couche 21 enterrée en dioxyde de silicium, dénommée BOX (acronyme de « Burried Oxide » signifiant oxyde enterré). Cette couche 21 présente typiquement une épaisseur comprise entre 30 nm et 200 nm, par exemple de l'ordre de 40 nm.
- une couche active 12 en silicium, dénommée top Si (signifiant silicium supérieur). Cette couche active 12 présente de préférence une épaisseur comprise entre 5 nm et 50 nm, par exemple de l'ordre de 10 nm.

La face supérieure 121 de la couche active 12 est surmontée d'un empilement de grille ou motif de grille 10. De manière classique, le motif de grille 10 peut présenter successivement les couches suivantes disposées à partir de la couche active 12 : une couche d'oxyde d'interface (souvent désignée oxyde de grille), une grille en silicium polycristallin dit polySi et un masque dur. Alternativement ce motif de grille peut comprendre une couche à haute constante diélectrique, dite couche « high k » surmontée par une grille métallique.

Le motif de grille 10 présente typiquement une hauteur, selon z, de plusieurs dizaines de nanomètres à plusieurs centaines de nanomètres.

Dans la suite de la description, et par souci de concision, le motif de grille sera simplement désigné grille 10. L'invention couvre également un mode de réalisation alternatif pour lequel le motif de grille 10 est un motif sacrificiel destiné à être retiré après réalisation des espaceurs, puis à être remplacé par un autre empilement de grille formant une grille 10. Un tel procédé est couramment qualifié de «gate last» selon la terminologie anglo-saxonne. La grille 10 dans la suite désigne donc indifféremment un empilement de grille de type de type « gate first » (la grille est conservée à l'issue de la réalisation des espaceurs) ou de type « gate last » (la grille est remplacée à l'issue de la réalisation des espaceurs).

La couche active est désignée topSi 12. La zone dopée destinée à former la source ou le drain du transistor est désignée zone S/D 13.

Après structuration ou fourniture de la grille 10 et avant formation des espaceurs 11 sur les flancs 100 de la grille 10, une portion 12m du topSi 12, qui n'est ni masquée, ni couverte par la grille 10, ni par des espaceurs, est modifiée (figure 2B). Cette portion modifiée 12m présente alors une interface 125 avec la portion 12e non modifiée de topSi, qui elle est couverte par la grille 10. C'est dans la portion 12e non modifiée que le canal 15 du transistor sera formé ultérieurement. L'interface 125 entre la portion modifiée 12m et la portion non modifiée 12e est sensiblement parallèle à z, dans un prolongement du flanc 100 de la grille 10. Cela permet d'aligner ultérieurement la jonction entre le canal et la zone S/D du transistor directement en bordure de la grille 10. Cela évite qu'une portion non dopée subsiste entre le canal 15 et la zone S/D ultérieurement formée. La résistance d'accès au transistor est alors diminuée.

La portion modifiée 12m présente de préférence une épaisseur égale à l'épaisseur de la couche active 12. Cela évite qu'une portion non dopée subsiste en dehors du canal 15, sous la zone S/D ultérieurement formée. La résistance d'accès au transistor est alors diminuée. Une telle portion modifiée 12m s'étend ainsi jusqu'à l'interface 212 avec le BOX 21. Il n'est donc pas nécessaire de contrôler précisément l'arrêt en profondeur de la modification. Le contrôle en profondeur de la modification du topSi est ainsi facilité.

La modification du topSi 12 est configurée pour créer une différence entre les propriétés de gravure du Si modifié de la portion 12m et du Si cristallin du canal 15. Cette modification peut être effectuée par implantation ionique ou par plasma. La modification est de préférence réalisée de façon anisotrope, selon une direction principalement dirigée selon z. Cela ne modifie donc pas la portion 12e masquée par la grille 10, selon cette direction z.

Cette modification peut être structurelle. Elle peut induire un changement de phase de la couche active 12 cristalline de façon à créer une portion modifiée 12e amorphe. Cette modification ne vise pas à pulvériser le topSi 12.

Il est à noter qu'après amorphisation de la couche topSi 12 et avant retrait de la portion modifiée 12m, toute étape de microélectronique est de préférence réalisée à une température inférieure à la température de recristallisation de la couche modifiée 12m. Par exemple, la couche déposée/gravée postérieurement à l'amorphisation peut être déposée/gravée à une température inférieure à la température de recristallisation de la couche modifiée 12m. Lorsque la couche de topSi est en silicium, la température de dépôt/gravure peut être inférieure à 700°C, de préférence inférieure à 600°C et idéalement inférieure à 500°C pour éviter la recristallisation de la couche de silicium amorphe 12m. Lorsque la couche de topSi est en germanium, la température de dépôt/gravure peut être inférieure à 600°C, de préférence inférieure à 500°C et idéalement inférieure à 400°C pour éviter la recristallisation de la couche de germanium amorphe 12m.

Alternativement ou en combinaison, cette modification peut être chimique. Elle peut comprendre une introduction d'espèces chimiques visant à modifier les propriétés de gravure et/ou la nature du matériau semi-conducteur.

Selon une possibilité, cette modification anisotrope est effectuée par implantation anisotrope d'ions sur au moins toute l'épaisseur du topSi 12.

Cette modification anisotrope peut être effectuée dans un implanteur ou à partir d'un plasma.

Selon une possibilité, l'implantation anisotrope peut être réalisée dans un implanteur classique. L'angle d'implantation reste constant tout au long de l'implantation. Cette inclinaison est parallèle au flanc 100 de la grille 10.

Les espèces implantées peuvent être par exemple du Silicium (Si), du Germanium (Ge) de l'argon (Ar), de l'oxygène (O) ou de l'azote (N).

Les conditions d'implantation peuvent être déterminées par simulation à l'aide d'un outil de type SRIM (acronyme de « Stopping and Range of Ions in Matter ») ou TRIM (acronyme de « Transport of ions in matter »).

Après modification, les propriétés de gravure de la portion modifiée 12m vis-à-vis de la portion non modifiée 12e sont de préférence telles que :
le matériau semi-conducteur modifié présente une vitesse de gravure plus élevée que le matériau semi-conducteur non modifié, pour une chimie de gravure donnée, et/ou,
le matériau semi-conducteur modifié présente une réactivité à un ou plusieurs réactifs chimiques plus élevée que le matériau semi-conducteur non modifié.

L'espaceur 11 est formé après modification du topSi 12 et de préférence avant retrait de la portion modifiée 12m. L'espaceur 11 est typiquement formé par dépôt d'une couche 110 en un matériau diélectrique sur la grille 10 et sur la couche active 12, de préférence de façon conforme (figure 2C). Une étape de gravure anisotrope selon z permet ensuite de retirer des portions horizontales de ladite couche diélectrique 110 au sommet de la grille 10 et sur une partie de la couche active 12, tout en conservant une portion verticale de couche diélectrique sur le flanc 100 de la grille 10. Cette portion verticale forme l'espaceur 11. La couche diélectrique peut être en nitrure de silicium SiN ou en SiCO (silicium carbone oxygène).

Selon un mode de réalisation, la gravure anisotrope visant à former l'espaceur 11 peut être configurée pour s'arrêter au niveau de la face supérieure 120 de la portion modifiée 12m (figure 2D). L'arrêt de la gravure sur la face supérieure 120 de la portion modifiée 12m peut être réalisé en contrôlant le temps de gravure, ou par une détection de fin d'attaque dans un réacteur plasma, ou encore en recourant à une solution de gravure présentant une sélectivité suffisante, par exemple supérieure à 10:1, entre le matériau diélectrique et le matériau semi-conducteur modifié de la portion modifiée 12m.

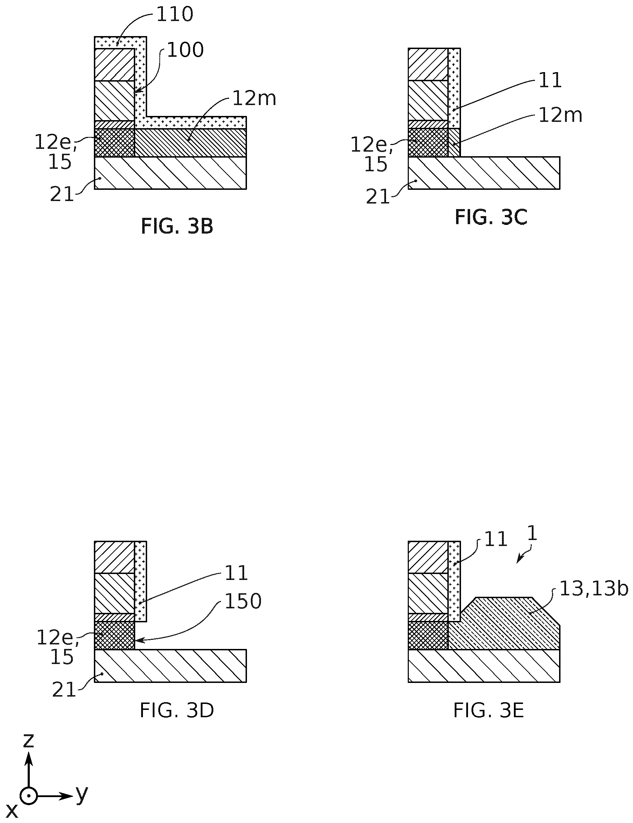

Selon un mode de réalisation alternatif illustré aux figures 3B-3E, la gravure anisotrope visant à former l'espaceur 11 peut être configurée pour graver également la portion modifiée 12m (figures 3B-3C) non masquée par l'espaceur 11. Selon ce mode alternatif, la solution de gravure présente de préférence peu ou pas de sélectivité entre le matériau diélectrique et le matériau semi-conducteur modifié. Cela permet d'économiser une étape de procédé. Afin de poursuivre la gravure de la portion modifiée 12m sous l'espaceur 11, une étape de gravure isotrope et sélective est de préférence effectuée. Cette gravure isotrope et sélective peut présenter une sélectivité supérieure à 10:1 entre le matériau semi-conducteur modifié et le matériau semi-conducteur. Cela permet de retirer la portion modifiée 12m sous l'espaceur 11 en conservant la portion non modifiée 12e, comme illustré à la figure 3D.

Selon un autre exemple, la gravure anisotrope visant à former l'espaceur 11 est suivie par une gravure anisotrope du matériau semi-conducteur modifié, par exemple le silicium amorphe. Cette dernière gravure n'est pas nécessairement sélective vis-à-vis du matériau semi-conducteur non modifié, par exemple le silicium cristallin. Elle est alors suivie par une gravure isotrope et sélective du matériau semi-conducteur modifié vis-à-vis du matériau semi-conducteur non modifié, pour retirer la portion modifiée 12m sous l'espaceur 11.

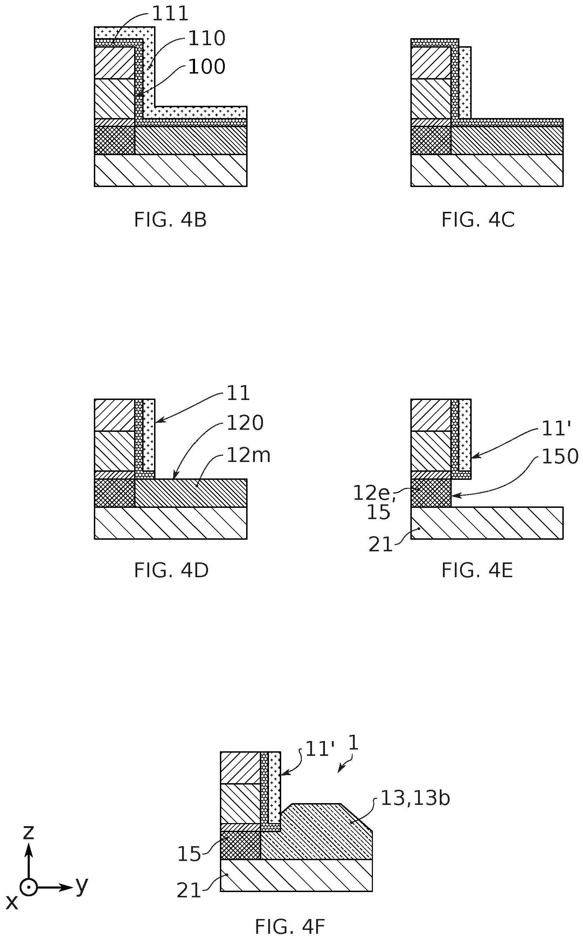

Selon un mode de réalisation alternatif illustré aux figures 4B-4F, une couche de protection 111 de quelques nanomètres d'épaisseur, par exemple comprise entre 1 nm et 3 nm, peut être déposée préalablement au dépôt de la couche diélectrique 110 (figure 4B). L'espaceur 11' est dès lors formé en deux temps. Une première gravure anisotrope dirigée selon z permet de retirer des portions horizontales de couche diélectrique 110 tout en conservant une portion verticale de couche diélectrique 110 (figure 4C). Une deuxième gravure permet de retirer des portions horizontales de couche de protection 111 tout en conservant une portion verticale de couche de protection 111 (figure 4D). La couche de protection 111 est ici utilisée pour protéger la portion modifiée 12m lors de la première gravure anisotrope de la couche diélectrique 110. La couche de protection 110 peut être en dioxyde de silicium. La première gravure peut se faire par plasma à partir d'espèces fluorocarbonnées. La deuxième gravure peut être une gravure humide à base de HF dilué. Une telle deuxième gravure présente une sélectivité suffisante vis-à-vis du matériau semi-conducteur modifié. Cette deuxième gravure peut alternativement se faire par gravure ionique réactive RIE.

Dans tous les cas, la portion modifiée 12m est retirée sélectivement à la portion non modifiée 12e (figures 2E, 3D, 4E). Ce retrait se fait typiquement par gravure sélective du matériau semi-conducteur modifié vis-à-vis du matériau semi-conducteur non modifié. La sélectivité de gravure peut être supérieure ou égale à 5:1, et de préférence supérieure ou égale à 10:1.

Des méthodes de gravure sélective de Si amorphe et d'alliages de Si vis-à-vis de Si cristallin, telles que décrites dans le document « Low temperature catalyst enhanced etch process with high etch rate selectivity for amorphous silicon based alloys over single-crystalline silicon based alloys, M Bauer », ou dans le document « SELECTIVE ETCHING OF AMORPHOUS SILICON OVER EPITAXIAL SILICON, US 9,991,129 B1 » peuvent être utilisées pour graver la portion modifiée 12m sélectivement à la portion non modifiée 12e. Cette gravure sélective de Si amorphe peut être effectuée par exemple à l'aide d'un mélange gazeux contenant des atomes de chlore. Selon un exemple, le mélange gazeux est à base d'acide chlorhydrique. Selon un autre exemple, le mélange gazeux est à base d'acide chlorhydrique, de germane et éventuellement de dihydrogène.

Cette gravure sélective permet d'exposer un flanc 150 de la portion non modifiée 12e. Ce flanc 150 est sensiblement parallèle à z, dans un prolongement du flanc 100 de la grille 10. Ce flanc 150 est avantageusement utilisé pour former par épitaxie latérale, selon une direction sensiblement normale au flanc 150, la zone dopée 13. Le flanc 150 devient dès lors une interface formant une jonction entre le canal 15 et la zone dopée 13. Cette jonction est avantageusement située directement en bordure de la grille 10, à l'aplomb du flanc 100. La résistance d'accès au transistor peut ainsi être diminuée.

Comme illustré aux figures 2F, 2G, l'épitaxie latérale se fait à partir du flanc 150, de préférence uniquement à partir du bord 150, d'abord et principalement selon l'axe y (portion 13a de la zone dopée 13 sur la figure 2F). Cette épitaxie de la zone dopée 13 peut se poursuivre en partie selon z (portion 13b de la zone dopée 13 sur les figures 2G, 3E, 4F). Une telle configuration de transistor 1 comprenant des zones S/D surélevées est appelée RSD, acronyme anglais de « Raised Source/Drain ».

Un procédé d'épitaxie dopée *in situ* est de préférence mis en œuvre pour former la zone dopée 13. Un dopage bore ( :B) ou phosphore ( :P) peut ainsi être obtenu. La zone dopée 13 peut être par exemple à base de SiGe:B, Si:B ou Si:P.

Selon une possibilité, une cavité se forme entre le BOX 21 et la zone dopée 13, 13b, lors de l'épitaxie latérale. Une telle cavité améliore l'isolation électrique entre la zone dopée 13 et le substrat sous-jacent au BOX 21.

Selon une possibilité, préalablement à l'amorphisation de la couche de topSi 12, une fine couche d'oxyde de silicium est déposée sur le motif de grille 10, puis gravée (par exemple à l'aide d'une chimie à base de HF) pour former une fine couche d'oxyde de silicium uniquement sur les flancs 100 de la grille. Cette couche d'oxyde de silicium présente une largeur inférieure ou égale à 3 nm, de préférence inférieure ou égale à 1nm. Compte tenu de la faible largeur de cette couche, celle-ci ne peut pas être assimilée à un espaceur qui présente généralement une largeur de 6nm à 40nm, lui permettant d'isoler la grille. Le rôle de cette fine couche d'oxyde de silicium est d'éviter un phénomène de « dispersion latérale » ou « latéral straggling» lors de l'amorphisation de la couche de topSi 12. Dans le présent document, il est entendu que le terme «flanc latéral» correspondant à la référence 100 sur les figures peut inclure cette fine couche d'oxyde de silicium. Le motif de grille peut ainsi comprendre cette fine couche d'oxyde de silicium.

L'invention n'est pas limitée aux modes de réalisations précédemment décrits et s'étend à tous les modes de réalisation conformes à son esprit.

## Revendications

1. Procédé de formation d'au moins une zone dopée (13) destinée à former une source et/ou un drain d'un transistor (1), comprenant les étapes suivantes :
- Fournir un empilement comprenant au moins une couche active (12) en un matériau semi-conducteur, et un motif de grille (10) de transistor surmontant la couche active (12) et présentant au moins un flanc latéral (100) s'étendant dans un plan sensiblement perpendiculaire à une face (121) de la couche active (12), ledit flanc latéral (100) étant exposé, puis
- Modifier une portion de la couche active (12) selon toute l'épaisseur de la couche active (12) de sorte à former une portion modifiée (12m) en un matériau semi-conducteur modifié, ladite portion modifiée (12m) s'étendant dans une région de la couche active (12) non surmontée par le motif de grille (10) et s'étendant jusqu'à l'aplomb de l'au moins un flanc latéral (100) du motif de grille (10), la région de la couche active (12) située sous le motif de grille (10) formant une portion non modifiée (12e, 15), puis
- Former un espaceur (11) sur ledit flanc latéral (100) du motif de grille (10),
- Retirer la portion modifiée (12m) par gravure sélective du matériau semi-conducteur modifié vis-à-vis du matériau semi-conducteur de la portion non modifiée (12e, 15), de sorte à exposer un bord (150) de ladite portion non modifiée (12e, 15), ledit bord (150) s'étendant dans un prolongement du flanc latéral (100) du motif de grille (10),
- Former la zone dopée (13) par épitaxie à partir dudit bord (150) exposé.

2. Procédé selon la revendication précédente dans lequel la sélectivité de la gravure du matériau semi-conducteur modifié vis-à-vis du matériau semi-conducteur est supérieure ou égale à 10 :1, et de préférence supérieure ou égale à 20 :1.

3. Procédé selon l'une quelconque des revendications précédentes dans lequel la formation de l'espaceur (11) comprend au moins un dépôt d'une couche diélectrique (110) au moins sur le motif de grille (10) suivi d'une gravure partielle de ladite couche diélectrique (110) de sorte à retirer ladite couche diélectrique (110) en dehors de l'au moins un flanc latéral (100), et dans lequel le retrait de la portion modifiée (12m) est effectué par ladite gravure partielle.

4. Procédé selon l'une quelconque des revendications précédentes comprenant en outre, après modification de la portion de la couche active (12) et avant formation de l'espaceur (11), une formation d'une couche de protection (111) sur une face (120) exposée de la portion modifiée (12m), ladite couche de protection (111) étant retirée après formation de l'espaceur (11) et avant retrait de la portion modifiée (12m).

5. Procédé selon l'une quelconque des revendications précédentes dans lequel la modification de la portion de la couche active (12) est effectuée de sorte à ce que la portion modifiée (12m) soit amorphe, ladite portion non modifiée (12e, 15) étant cristalline.

6. Procédé selon l'une quelconque des revendications précédentes dans lequel la modification de la portion de la couche active (12) est effectuée de sorte à ce que le matériau semi-conducteur modifié présente une composition chimique différente du matériau semi-conducteur.

7. Procédé selon la revendication précédente dans lequel la modification de la portion de la couche active se fait par implantation d'espèces au sein de la couche active (12).

8. Procédé selon la revendication précédente dans lequel l'implantation d'espèces au sein de la couche active (12) est effectuée à partir d'un plasma.

9. Procédé selon l'une quelconque des revendications précédentes dans lequel le matériau semiconducteur de la couche active (12) est pris parmi le silicium et le silicium-germanium, et dans lequel la zone dopée (13) est à base de silicium ou de silicium-germanium.

10. Procédé selon l'une quelconque des revendications précédentes dans lequel l'épitaxie de la zone dopée (13) est configurée pour que ladite zone dopée (13) s'étende au-delà d'une face (121) supérieure de la couche active (12) selon une direction sensiblement perpendiculaire à ladite face (121) supérieure de la couche active (12).

11. Procédé selon la revendication précédente dans lequel l'épitaxie de la zone dopée (13) est une épitaxie latérale principalement, de préférence uniquement, dirigée selon une direction parallèle à la face (121) de la couche active (12).

12. Procédé selon l'une quelconque des deux revendications précédentes dans lequel la gravure sélective est anisotrope et principalement dirigée selon une direction perpendiculaire à la face (121) de la couche active (12).

13. Procédé selon l'une quelconque des revendications précédentes dans lequel l'épitaxie de la zone dopée est configurée de façon à former une cavité sous la zone dopée (13).
